# EUROPÄISCHE PATENTSCHRIFT

(11) **EP 1 362 403 B1**
(45) Veröffentlichungstag und Bekanntmachung des Hinweises auf die Patenterteilung: **27.05.2009**
(21) Anmeldenummer: 01989366.8
(22) Anmeldetag: 05.12.2001
(51) Int. Cl.: H02J 7/14

(54) **VORRICHTUNG ZUR FEHLERERKENNUNG IN EINEM MEHRSPANNUNGSBORDNETZ**
ERROR DETECTION DEVICE FOR A MULTI-VOLTAGE VEHICLE POWER SUPPLY
DISPOSITIF DE DETECTION D'ERREUR DANS UN RESEAU DE BORD MULTITENSION

(30) Priorität: 08.12.2000 DE 10061046
(43) Veröffentlichungstag der Anmeldung: 19.11.2003
(73) Patentinhaber: ROBERT BOSCH GMBH, 70442 Stuttgart (DE)
(72) Erfinder: JEHLICKA, Joerg, 71229 Leonberg (DE); HADELER, Ralf, 21339 Lüneburg (DE)
(86) Internationale Anmeldenummer: PCT/DE2001/004563
(87) Internationale Veröffentlichungsnummer: WO 2002/047235

(56) Entgegenhaltungen:
- DE-A- 4 338 462
- DE-A- 19 755 050
- DE-A- 19 855 245
- US-A- 5 856 711

## Beschreibung

### Stand der Technik

Die Erfindung geht aus von einer Vorrichtung zur Fehlererkennung in einem Mehrspannungsbordnetz nach der Gattung des unabhängigen Anspruchs. In Bordnetzen mit einer Vielzahl von elektrischen Verbrauchern, beispielsweise in Kraftfahrzeugbordnetzen, besteht das Problem, dass eine 12V-Spannung zur Energieversorgung nicht mehr ausreicht. Da einige der Verbraucher mit einer höheren Spannung als 12V versorgt werden sollten, sind Mehrspannungsbordnetze bekannt, die zwei unterschiedliche Spannungsebenen aufweisen. Eine erste Spannungsebene liegt gegenüber Masse auf +12V, eine zweite Spannungsebene auf +36V, wobei diese Spannungen jeweils die Nennspannungen sind. Die Verbindung zwischen den beiden Spannungsebenen wird mit Hilfe eines Gleichspannungswandlers hergestellt. Ein solches Mehrspannungsbordnetz in einem Kraftfahrzeug wird in der DE-A 198 45 569 beschrieben. Die elektrische Energie wird in diesem Bordnetz mit Hilfe eines Drehstromgenerators erzeugt, der vom Fahrzeugmotor angetrieben wird und eine Ausgangsspannung von 42V (Ladespannung) liefert. Mit dieser Ladespannung wird eine 36V- (Nennspannung) Batterie geladen. Über den Gleichspannungswandler wird eine 12V-Batterie mit einer Ladespannung von 14V versorgt.

An die beiden Batterien können über geeignete Schalter die elektrischen Verbraucher zugeschaltet werden, wobei die 12V-Batterie die herkömmlichen Bordnetzverbraucher, beispielsweise Glühlampen versorgt, während die 36V-Batterie zur Versorgung von Hochleistungsverbrauchern, beispielsweise Scheibenheizungen verwendet wird. Bei dem bekannten Bordnetz liegen die negativen Anschlüsse der beiden Batterien jeweils auf demselben Massepotential. Maßnahmen, die zur Verhinderung eines Kurzschlusses zwischen der 12V- bzw. 14V-Spannungsebene und der 36V- bzw. 42V-Spannungsebene dienen, werden in der DE-A 198 45 569 nicht angesprochen.

Aus der DE 197 04 166 A1 ist eine gemeinsame Sicherung für zeitlich veränderliche Lastkreise bekannt, bei der mehrere mit einer gemeinsamen Spannungsquelle oder mit verschiedenen Spannungsquellen verbundene Verbraucher in einem Kraftfahrzeug über Lastschalter unabhängig voneinander ein- und ausgeschaltet werden. Dabei vergleicht ein Prüfteil den gesamten Laststrom mit einem Referenzstrom, der dem Schaltzustand der Lastschalter proportional ist. Überschreitet der gesamte Laststrom den Referenzstrom, so werden alle Lastschalter geöffnet, und die Meldung "Überstrom" wird vom Prüfteil abgegeben. Unterschreitet der gesamte Laststrom den Referenzstrom, so wird die Meldung "Unterstrom" vom Prüfteil abgegeben.

### Vorteile der Erfindung

Die Vorrichtung zur Fehlererkennung in einem Mehrspannungsbordnetz umfasst ein Leistungsverteiler, der über zumindest einen Ausgang die Energieversorgung zumindest einer elektrischen Last beeinflusst. Es sind Erfassungsmittel vorgesehen, die zumindest eine elektrische Größe am Ausgang erfassen. Weiterhin ist zumindest eine Signalverarbeitung vorgesehen, die die elektrische Größe mit zumindest einem Grenzwert vergleicht, wobei in Abhängigkeit von dem Vergleich ein Fehlerzustand erkannt ist. Zur Fehlererkennung wird als Grenzwert beispielsweise ein Sollwert verwendet, mit dem die elektrische Last angesteuert wird. Dadurch wird in vorteilhafter Weise erreicht, dass zu definierten Zuständen und Zeitpunkten die entsprechenden Soll- und Istgrößen verglichen werden können. Dank der Auswertung kann ein Kurzschluß oder ein Masseverlust erkannt werden. Diese zusätzliche Diagnosefunktion läßt sich besonders einfach realisieren, da die Erfassungsmittel ohnehin in dem Leistungsverteiler zur Verfügung stehen. Auch der Sollwert, mit dem die Last zu beaufschlagen ist, kann der Signalverarbeitung leicht zur Verfügung gestellt werden. So kann die

Signalverarbeitung entweder den Sollwert selbst generieren und die entsprechende Ansteuerung der Last bewirken, oder aber der Sollwert wird beispielsweise über ein ohnehin vorhandenes Bussystem mitgeteilt. Erfindungsgemäß ist vorgesehen, dass die Signalverarbeitung im geöffneten Zustand des Schaltmittels als elektrische Größe die an dem Ausgang des Leistungsverteilers anliegende Spannung erfasst. Dabei lässt eine deutlich von Null abweichende Ausgangsspannung auf einen Kurzsschluss oder einen Masseverlust schliessen, sofern ein weiterer elektrischer Verbraucher, der ebenfalls an einem Potentialsammelpunkt angeschlossen ist, aktiviert wurde.

In einer zweckmäßigen Weiterbildung wird die Vorrichtung zur Fehlererkennung vor dem Start des Kraftfahrzeugs aktiviert, da es sich gezeigt hat, dass ein großer Teil der Fehlerfälle (Kurzschluss, Masseverlust) bei Manipulationen am Kraftfahrzeug im Stillstand erzeugt wird. Zudem ist es vor dem start des Kraftfahrzeugs eher erlaubt, die Verbraucher (ohne Fahrerwunsch) frei anzusteuern. Die einem Fahrzeugstart vorangehende Diagnose kann geeignete Gegenmaßnahmen einleiten, um dem Benutzer auf einen fehlerhaften Zustand des Kraftfahrzeugs aufmerksam zu machen oder ihn gar am Start zu hindern. Dadurch erhöht sich für den Benutzer die Betriebssicherheit des Kraftfahrzeugs.

In einer zweckmäßigen Weiterbildung wird als elektrische Größe der Strom am Ausgang des Leistungsverteilers erfasst, mit dem die am Ausgang angeschlossene elektrische Last beaufschlagt wurde. So wird die elektrische Last beispielsweise gezielt mit einem Sollstrom von I = 0 A beaufschlagt. Die Erfassungsmittel erfassen den Ausgangsstrom, also den tatsächlichen Iststrom, mit dem die Last beaufschlagt wird. Bei einer deutlichen Abweichung zwischen Sollstrom und Iststrom kann auf einen Kurzschluss geschlossen werden.

In einer zweckmäßigen Weiterbildung ist vorgesehen, die elektrische Last mit einem von null verschiedenen Sollstrom anzusteuern. Liegt nun der erfasste Iststrom oberhalb des von dem Sollwert festgelegte Erwartungsbereichs, wird auf Kurzschluss erkannt, liegt er unterhalb des Erwartungsbereichs, wird auf Masseverlust erkannt. Anhand dieser Ansteuerart lassen sich bereits mehrere Fehlerquellen gezielt eingrenzen. Dies verbessert die Diagnosefähigkeit des Systems.

Weitere zweckmäßige Weiterbildungen ergeben sich aus weiteren abhängigen Ansprüchen und aus der Beschreibung.

### Zeichnung

Ein Ausführungsbeispiel der erfindungsgemäßen Vorrichtung ist in der Zeichnung dargestellt und wird nachfolgend näher erläutert.

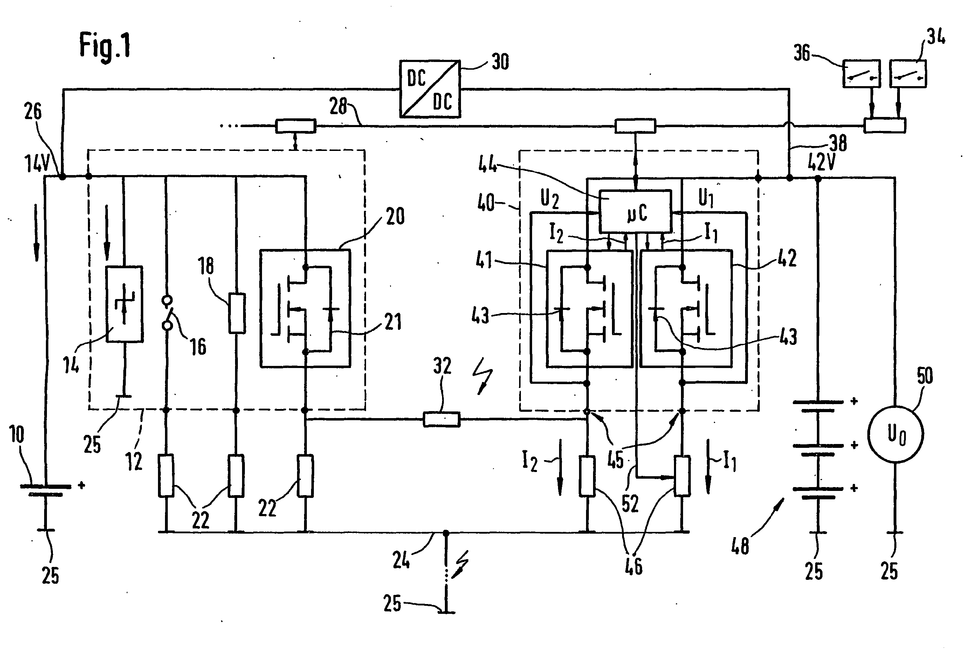

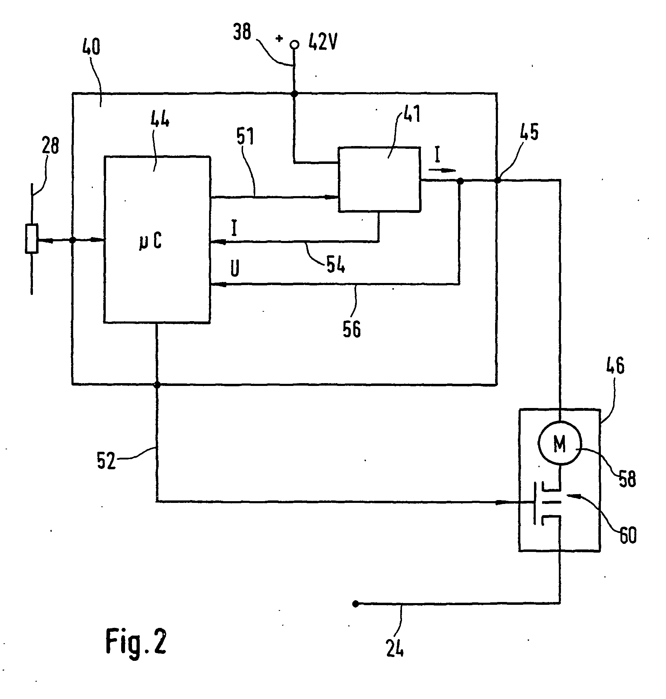

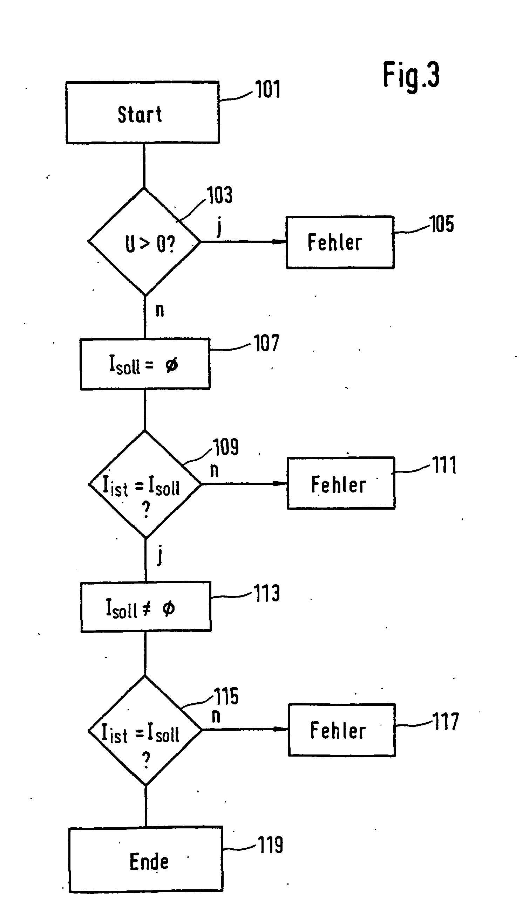

Es zeigen die Figur 1 eine prinzipielle Anordnung in einem Zweispannungsbordnetz, die Figur 2 eine genauere Darstellung des Leistungsverteilers der Figur 1 sowie Figur 3 ein Flußdiagramm der Fehlererkennungsprozedur.

### Beschreibung des Ausführungsbeispiels

Eine erste Batterie 10 mit 12V-Nennspannung ist zwischen Masse 25 und einem 14V-Versorgungszweig 26 verschaltet. Ein 14V-Leistungsverteiler 12 wird über diesen 14V-Versorgungszweig 26 mit Energie versorgt. In dem 14V-Leistungsverteiler sind eine Spannungsbegrenzung 14, ein Relais 16, eine Sicherung 18 sowie ein 14V-seitiger Leistungshalbleiter 20 mit dem 14V-Versorgungszweig 26 elektrisch leitend verbunden. Die Spannungsbegrenzung 14 ist wiederum mit Masse verbunden. Durch den 14V-Leistungsverteiler 12 werden beispielhaft dargestellt drei 14V-Verbraucher mit elektrischer Energie versorgt. So können die 14V-Verbraucher 22 beispielsweise über das Relais 16 oder den 14V-seitigen Leistungshalbleiter 20 zugeschaltet werden, indem ein über ein Bussystem 28 zugeführter Befehl zu einer entsprechenden Ansteuerung führt. Der 14V-Versorgungszweig 26 ist über einen DC/DC-Wandler 30 mit einem 42V-Versorgungszweig 38 elektrisch leitend verbunden. Der 42V-Versorgungszweig 38 wird gespeist von einer zweiten Batterie 48, die gegen Masse 25 geschaltet ist. Bei der zweiten Batterie 48 handelt es sich vorzugsweise um eine Batterie mit 36V Nennspannung. Diese zweite Batterie 48 kann über einen parallel verschalteten Generator 50 geladen werden. Ein 42V-Leistungsverteiler 40 dient der Lastverteilung für 42V-Verbraucher 46. Dem 42V-Leistungsverteiler 40 wird einerseits die 42V-Versorgungsspannung über den 42V-Versorgungszweig 38 zugeführt. Andererseits ist der 42V-Leistungsverteiler 40 mit dem Bussystem 28 zum Datenaustausch verbunden. Im 42V-Leistungsverteiler 40 sind exemplarisch ein erster und ein zweiter Leistungshalbleiter 41, 42 dargestellt, die jeweils 42V-Verbraucher 46 auf 42V-Potential legen können. Beide Leistungshalbleiter 41, 42 weisen jeweils eine Inversdiode 43 auf. Die Ansteuerung der Leistunghalbleiter 41, 42 übernimmt ein Mikrocontroller 44. Der Mikrocontroller 44 erhält die von den Leistungshalbleitern 41, 42 durchflossenen und sensierten Ströme I1, I2 an den Ausgängen 45. Außerdem werden dem Mikrocontroller 44 die an den Ausgängen 45 jeweils anliegenden Potentiale bzw. Spannungen U1, U2 zugeführt. Die 42V-Verbraucher 45 sind einerseits mit den Ausgängen 45 des 42V-Leistungsverteilers 40, andererseits mit einem Potentialsammelpunkt 24 elektrisch leitend verbunden. Auch die 14V-Verbraucher 22 sind mit diesem Potentialsammelpunkt 24 kontaktiert. Wie durch den Blitz angedeutet, besteht jedoch fehlerhafter Weise keine elektrische Verbindung zwischen dem Potentialsammelpunkt 24 und dem Massepotential 25. Dieser Fehlerfall wird nachfolgend als "Masseverlust" bezeichnet. Als weiterer Fehlerfall ist mit Hilfe des Kurzschlusswiderstands 32 ein Kurzschluss zwischen einem der 14V-Verbraucher 22 und einem der 42V-Verbraucher 46 skizziert. In diesem dargestellten Fehlerfall würde sich aufgrund der Inversdiode 21 des 14V-seitigen Leistungshalbleiters 20 für den 14V-Versorgungszweig des 14V-Leistungsverteilers 12 ein erhöhtes Spannungsniveau von ca. 24V einstellen. Weiterhin läßt sich über das Bussystem 28 der Zustand eines Zündungskontaktschalters 34 und eines Türkontaktschalters 36 bereitstellen.

In Figur 2 ist der prinzipielle Aufbau des 42V-Leistungsverteilers 40 genauer gezeigt. Er enthält den Mikrocontroller 44, der Daten über ein Bussystem 28 austauscht. Weiterhin ist dem ersten Leistungshalbleiter 41 über den 42V-Versorgungzweig 38 eine Spannung von 42V zugeführt. Der erste Leistungshalbleiter 41 wird von dem Mikrocontroller 44 über ein erstes Ansteuersignal 51 gesteuert. Der beispielsweise als Sense-FET ausgeführte Leistungshalbleiter 41 liefert den Stromistwert 54, mit dem der Leistungshalbleiter 41 beaufschlagt wird zur Ansteuerung des 42V-Verbrauchers 46. Außerdem wird dem Mikrocontroller 44 der am Ausgang 45 anliegende Spannungsistwert 56 zugeführt. Weiterhin erzeugt der Mikrocontroller 44 ein zweites Ansteuersignal 52, mit dem ein in unmittelbarer Nähe der Last 46 angeordnetes Schaltmittel 60 aktiviert oder deaktiviert werden kann. Als elektrische Last 46 ist im Ausführungsbeispiel ein Elektromotor 58 vorgesehen. Der 42V-Verbraucher ist mit dem Potentialsammelpunkt 24 verbunden.

Nachfolgend wird die Betriebsweise der Vorrichtung zur Fehlererkennung in einem Mehrspannungsbordnetz eines Kraftfahrzeugs in Verbindung mit Figur 3 näher beschrieben. Es wird davon ausgegangen, dass sich das Kraftfahrzeug im ordnungsgemäß abgestellten Zustand befindet. Ein Benutzer möchte nun den Start des Kraftfahrzeugs einleiten. Das Öffnen der Tür beim Einsteigen des Fahrers wird durch den Türkontaktschalter 36 sensiert. Das Ausgangssignal des Türkontaktschalters 36 kann nun beispielsweise über das Bussystem 28 dem 42V-Leistungsverteiler zugeführt werden, um den Mikrocontroller 44 des 42V-Leistungsvetreilers von dem Stand-by-Modus in den Normalbetrieb zu versetzen. Beim Hochlauf des 42V-Leistungsverteilers 40 werden außerdem die nachfolgend beschriebenen Fehlererkennungsprozeduren durchgeführt. Anstelle des Türkontaktschalters könnte beispielsweise auch das Signal "Zündung ein", welches der Zündungskontaktschalter 34 liefert, herangezogen werden.

Mit der beschriebenen Aktivierung der Fehlererkennungsprozedur (Schritt 101) detektiert der Mikrocontroller 44 vor dem Einschalten des 42V-Verbrauchers 46 durch den ersten Leistungshalbleiter 41 den Spannungsistwert 56 am Ausgang 45. Der Mikrocontroller 44 ermittelt, ob der Spannungsistwert 56 deutlich von Null abweicht (Schritt 103). Dann kann auf einen Fehler geschlossen werden (Schritt 105). Ein deutlich von Null abweichender Spannungsistwert 56 wird sich allerdings nur dann einstellen, wenn bereits ein 14V-Verbraucher 22 aktiviert wurde. Bei einer von Null abweichenden Spannung 56 könnten zwei Fehlersituationen vorliegen. Entweder handelt es sich um einen Kurzschluss, wie in Figur 1 durch den Kurzschlusswiderstand 32 angedeutet. Oder aber Potentialsammelpunkt 24 und Massepotential 25 sind nicht mehr elektrisch leitend miteinander verbunden (Masseverlust). Bei einem deutlich von Null abweichendem Spannungsistwert 56 generiert der Mikrocontroller 44 in Schritt 105 eine Fehlermeldung, die über das Bussystem 28 zu einer nicht dargestellten Anzeige gelangt. Weiterhin könnte auch der Startvorgang des Kraftfahrzeugs unterbunden werden.

In einer zweiten Testroutine veranlasst nun der Mikrocontroller 44, den 42V-Verbraucher 46 mit einem Stromsollwert ISOLL = 0, der dem zweiten Ansteuersignal entspricht, zu beaufschlagen (Schritt 107). Die Leistungshalbleiter 41, 42 werden hierbei aktiviert und mit einem entsprechenden ersten Ansteuersignal 51 beaufschlagt, d.h. eingeschaltet. Bei dem Ausführungsbeispiel gemäß Figur 2 läßt sich der 42V-Verbraucher 46 extern über das Schaltmittel 60 in gewünschter Art und Weise aktivieren. Beispielhaft dargestellt erzeugt der Mikrocontroller 44 selbst diesen Stromsollwert ISOLL = 0 und gibt ihn in Form des zweiten Ansteuersignals 52 an das Schaltmittel 60 weiter. Nun erfasst der Mikrocontroller 44 den sich am Ausgang 45 einstellenden Stromistwert 54. Dieser Stromistwert 54 kann beispielsweise von dem elektrischen Halbleiter 41, der als Sense-FET ausgeführt ist, bereitgestellt werden. Der Mikrocontroller 44 vergleicht den erfassten Stromistwert 54 mit dem zweiten Ansteuersignal 52, dem vorgegebenen Stromsollwert ISOLL = 0 (Schritt 109). Weichen Stromistwert 54 und zweites Ansteuersignal 52 (Stromsollwert ISOLL) signifikant voneinander ab, so läßt dies auf das Vorliegen eines Kurzschlusses schliessen. Der Leistungsverteiler 40 schaltet die Versorgung des 42V-Verbrauchers 46 über den ersten Leistungshalbleiter 41 ab (Schritt 111). Wie bereits beschrieben, erzeugt der Mikrocontroller 44 eine Fehlermeldung und leitet die entsprechenden Gegenmaßnahmen ein.

In einer dritten Fehlererkennungsprozedur wird der 42V-Verbraucher 46 in einen definierten Zustand gebracht (Schritt 113). So gibt beispielsweise der Mikrocontroller 44 einen Stromsollwert ISOLL vor, der einen von Null verschiedenen Wert annimmt. Wiederum ist der 42V-Verbraucher 46 über den ersten Leistunghalbleiter 41 eingeschaltet. Das zweite Ansteuersignal 52 ist so gewählt, dass sich der Sollwert ISOLL einstellt. Hierbei kann beispielsweise eine pulsweitenmodulierte Ansteuerung des Schaltmittels 60 vorgesehen sein. Der Sollwert ISOLL legt hierbei die Pulsweite des Ansteuersignals 52 fest. Der sich bei dieser Ansteuerung einstellende Stromistwert 54 wird von dem Mikrocontroller 44 erfasst und mit dem Stromsollwert ISOLL bzw. dem zweiten Ansteuersignal 52 verglichen (Schritt 115). Liegt der Stromistwert 54 signifikant oberhalb des Erwartungsbereichs, d.h. oberhalb des Stromsollwerts ISOLL, wird auf Kurzschluss erkannt (Schritt 117). Liegt dagegen der Stromistwert 54 deutlich unterhalb des Stromsollwerts ISOLL, so kann auf einen Masseverlust geschlossen werden (Schritt 117). Denn bei fehlender Verbindung zwischen Potentialsammelpunkt 24 und Massepotential 25 durchfliesst der Strom auch noch den 14V-Verbraucher 22 über die Inversdiode des 12V-seitigen Leistungshalbleiters 20. Dadurch stellt sich ein anderer Stromistwert 54 ein, der niedriger als der Strom ist, der ordnungsgemäß zur Masse 25 hin abfliessen würde. Auch in diesen beiden Fehlerfällen der dritten Fehlererkennungsprozedur veranlasst der Mikrocontroller 44 die sofortige Abschaltung des ersten Leistungshalbleiters 41 durch eine entsprechende Vorgabe des ersten Ansteuersignals 51.

Läßt sich der 42V-Verbraucher 46 nicht extern über ein Schaltmittel 60 ansteuern, so veranlasst der Mikrocontroller 44 die Aktivierung des Verbrauchers 46 und vergleicht den sich dabei einstellenden Stromistwert 54 mit einem vorab im Mikrocontroller 44 hinterlegten erwarteten Stromwert. Die Fehlerdetektion ergibt sich aus diesem Vergleich in Übereinstimmung mit der bereits beschriebenen dritten Prozedur.

Das vorgeschlagene Konzept kann auch zur Diagnose während des Fahrbetriebs angewendet werden. Es wird somit zu allen Zeiten verglichen, ob der Stromistwert 46 im erwarteten Bereich liegt. Bei normalen Verbrauchern 46 kann der Sollstrom relativ leicht abgeschätzt werden. Bei extern steuerbaren Verbrauchern 46 hingegen kann der Erwartungsbereich eingegrenzt werden, wenn die Ansteuerinformationen (Sollwert) bekannt ist.

## Patentansprüche

1. Vorrichtung zur Fehlererkennung in einem Mehrspannungsbordnetz, für ein kraftfahrzeug mit einem Leistungsverteiler (40), der mithilfe zumindest eines Schaltmittels (41, 42) die Energieversorgung zumindest einer elektrischen Last (46) beeinflusst, mit Erfassungsmitteln (41, 42, 44), die zumindest eine elektrische Größe (54, 56) erfassen, mit der die elektrische Last (46) beaufschlagt ist, mit zumindest einer Signalverarbeitung (44), die die elektrische Größe (54, 56) mit zumindest einem Grenzwert vergleicht, wobei in Abhängigkeit von dem vergleich ein Fehlerzustand (105, 111, 117) erkannt ist und wobei die Signalverarbeitung (44) zur Fehlererkennung zumindest einen Sollwert (52), mit dem die elektrische Last (46) angesteuert wird, oder einen erwarteten Wert mit der elektrischen Größe (54, 56) vergleicht zur Erkennung des Fehlerzustands, **dadurch gekennzeichnet, dass** die Signalverarbeitung (44) im geöffneten Zustand des Schaltmittels (41, 42) als elektrische Größe die an einem Ausgang (45) des Leistungsverteilers (40) anliegende Spannung (56) erfasst.

2. Vorrichtung nach einem der vorhergehenden Ansprüche, **dadurch gekennzeichnet, dass** die Signalverarbeitung (44) das Schaltmittel (41, 42) ansteuert.

3. Vorrichtung nach einem der vorhergehenden Ansprüche, **dadurch gekennzeichnet, dass** die signalverarbeitung (44) das Schaltmittel (41, 42) im Sinne eines Schliessens ansteuert und als elektrische Größe den Stromistwert (54) erfasst.

4. Vorrichtung nach einem der vorhergehenden Ansprüche, **dadurch gekennzeichnet, dass** die elektrische Last (46) mit einem Sollstrom (52) von Null beaufschlagt ist und die Signalverarbeitung (44) den Stromistwert (54) mit dem Sollstrom (52) zur Fehlererkennung vergleicht.

5. Vorrichtung nach einem der vorhergehenden Ansprüche, **dadurch gekennzeichnet, dass** die elektrische Last (46) mit einem Sollstrom (52) von Null verschieden beaufschlagt ist und die Signalverarbeitung (44) den Stromistwert (54) mit dem Sollstrom (52) zur Fehlererkennung vergleicht.

6. Vorrichtung nach einem der vorhergehenden Ansprüche, **dadurch gekennzeichnet, dass** die Signalverarbeitung (44) den Sollwert erzeugt zur Ansteuerung der elektrischen Last (46).

7. Vorrichtung nach einem der vorhergehenden Ansprüche, **dadurch gekennzeichnet, dass** der Leistungsverteiler (40) in dem Kraftfahrzeug angeordnet ist.

8. Vorrichtung nach einem der vorhergehenden Ansprüche, **dadurch gekennzeichnet, dass** die Signalverarbeitung (44) in Abhängigkeit von einem Schaltsignal eines Schalters (34, 36) aktiviert ist.

9. Vorrichtung nach einem der vorhergehenden Ansprüchen, **dadurch gekennzeichnet, dass** als Schalter ein Türkontaktschalter (36) oder Zündstartschalter (34) verwendet ist.

## Claims

1. Apparatus for identifying faults in a multivoltage on-board electrical system for a motor vehicle, having a power distributor (40) which, with the aid of at least one switching means (41, 42), influences the supply of power to at least one electrical load (46), having detection means (41, 42, 44) which detect at least one electrical variable (54, 56) which is applied to the electrical load (46), having at least one signal processing means (44) which compares the electrical variable (54, 56) with at least one limit value, with a fault state (105, 111, 117) being identified as a function of the comparison, and with the signal processing means (44) comparing at least one setpoint value (52), with which the electrical load (46) is driven, or an expected value with the electrical variable (54, 56) for the purpose of identifying the fault state, **characterized in that** the signal processing means (44) detects the voltage (56) which is produced at an output (45) of the power distributor (40) as the electrical variable in the open state of the switching means (41, 42).

2. Apparatus according to Claim 1, **characterized in that** the signal processing means (44) drives the switching means (41, 42).

3. Apparatus according to either of the preceding claims, **characterized in that** the signal processing means (44) drives the switching means (41, 42) to close and detects the actual current value (54) as the electrical variable.

4. Apparatus according to one of the preceding claims, **characterized in that** a setpoint current (52) of zero is applied to the electrical load (46) and the signal processing means (44) compares the actual current value (54) with the setpoint current (52) for the purpose of fault identification.

5. Apparatus according to one of the preceding claims, **characterized in that** a setpoint current (52) different from zero is applied to the electrical load (46) and the signal processing means (44) compares the actual current value (54) with the setpoint current (52) for the purpose of fault identification.

6. Apparatus according to one of the preceding claims, **characterized in that** the signal processing means (44) generates the setpoint value for the purpose of driving the electrical load (46).

7. Apparatus according to one of the preceding claims, **characterized in that** the power distributor (40) is arranged in the motor vehicle.

8. Apparatus according to one of the preceding claims, **characterized in that** the signal processing means (44) is activated as a function of a switching signal from a switch (34, 36).

9. Apparatus according to one of the preceding claims, **characterized in that** the switch used is a door contact switch (36) or an ignition starter switch (34).

## Revendications

1. Dispositif de détection des défauts dans un réseau de bord à plusieurs tensions pour un véhicule automobile, comprenant un distributeur de puissance (40) qui, à l'aide d'au moins un moyen de commutation (41, 42), influence la distribution d'énergie d'au moins une charge électrique (46), comprenant des moyens de détection (41, 42, 44) qui détectent au moins une grandeur électrique (54, 56) à laquelle est soumise la charge électrique (46), comprenant au moins un dispositif de traitement de signal (44) qui compare la grandeur électrique (54, 56) avec au moins une valeur limite, une situation de défaut (105, 111, 117) étant détectée en fonction de la comparaison et le dispositif de traitement de signal (44) comparant au moins une valeur de consigne (52) avec laquelle est commandée la charge électrique (46) ou une valeur attendue avec la grandeur électrique (54, 56) en vue de détecter la situation de défaut, **caractérisé en ce que** le dispositif de traitement de signal (44), lorsque le moyen de commutation (41, 42) est ouvert, détecte comme grandeur électrique la tension (56) appliquée à une sortie (45) du distributeur de puissance (40).

2. Dispositif selon la revendication 1,
**caractérisé en ce que** le dispositif de traitement de signal (44) commande le moyen de commutation (41, 42).

3. Dispositif selon l'une des revendications précédentes, **caractérisé en ce que** le dispositif de traitement de signal (44) commande le moyen de commutation (41, 42) dans le sens d'une fermeture et détecte comme grandeur électrique la valeur réelle du courant (54).

4. Dispositif selon l'une des revendications précédentes, **caractérisé en ce que** la charge électrique (46) est soumise à un courant de consigne (52) nul et le dispositif de traitement de signal (44) compare la valeur réelle du courant (54) avec le courant de consigne (52) en vue de détecter un défaut.

5. Dispositif selon l'une des revendications précédentes, **caractérisé en ce que** la charge électrique (46) est soumise à un courant de consigne (52) différent de zéro et le dispositif de traitement de signal (44) compare la valeur réelle du courant (54) avec le courant de consigne (52) en vue de détecter un défaut.

6. Dispositif selon l'une des revendications précédentes, **caractérisé en ce que** le dispositif de traitement de signal (44) génère la valeur de consigne pour commander la charge électrique (46).

7. Dispositif selon l'une des revendications précédentes, **caractérisé en ce que** le distributeur de puissance (40) est disposé dans le véhicule automobile.

8. Dispositif selon l'une des revendications précédentes, **caractérisé en ce que** le dispositif de traitement de signal (44) est activé en fonction d'un signal de commutation d'un commutateur (34, 36).

9. Dispositif selon l'une des revendications précédentes, **caractérisé en ce que** le commutateur utilisé est un commutateur à contact de portière (36) ou un commutateur de démarrage (34).
